(19) **Europäisches Patentamt**
**European Patent Office**
**Office européen des brevets**

(11) **EP 1 383 162 B1**

(12) **EUROPEAN PATENT SPECIFICATION**

(45) Date of publication and mention
of the grant of the patent:
**02.01.2008 Bulletin 2008/01**

(51) Int Cl.:
*H01L 21/316* (2006.01)

(21) Application number: **02257887.6**

(22) Date of filing: **14.11.2002**

(54) **Deposition method of dielectric layer**

Methode, eine dielektrische Schicht abzuscheiden

Méthode de dépôt d'une couche diélectrique

(84) Designated Contracting States:
**DE FR GB**

(30) Priority: **20.07.2002 KR 2002042763**

(43) Date of publication of application:
**21.01.2004 Bulletin 2004/04**

(73) Proprietor: **SAMSUNG ELECTRONICS CO., LTD.**
**Suwon-City, Kyungki-do (KR)**

(72) Inventors:
• **Lee, Jung-hyun**
**Suwon-city,**
**Kyungki-do (KR)**
• **Cho, Young-jin**
**Bupyeong-gu,**
**Incheon (KR)**
• **Min, Yo-sep**
**Dongjak-gu,**
**Seoul (KR)**

(74) Representative: **Kyle, Diana**
**Elkington and Fife LLP,**
**Prospect House**
**8 Pembroke Road**
**Sevenoaks,**
**Kent TN13 1XR (GB)**

(56) References cited:
**EP-A- 0 540 994       EP-A- 1 341 217**
**WO-A-02/31875**

• CHOI H S ET AL: "ELECTRICAL CHARACTERISTICS OF PT/ SRBI2TA2O9/TA2O5/SI USING TA2O5 AS THE BUFFER LAYER" JAPANESE JOURNAL OF APPLIED PHYSICS, PUBLICATION OFFICE JAPANESE JOURNAL OF APPLIED PHYSICS. TOKYO, JP, vol. 40, no. 4B, PART 1, April 2001 (2001-04), pages 2940-2942, XP001081011 ISSN: 0021-4922
• CLARK-PHELPS R B ET AL: "ENGINEERED TANTALUM ALUMINATE AND HAFNIUM ALUMINATE ALD FILMS FOR ULTRATHIN DIELECTRIC FILMS WITH IMPROVED ELECTRICAL AND THERMAL PROPERTIES" MATERIALS RESEARCH SOCIETY SYMPOSIUM PROCEEDINGS, MATERIALS RESEARCH SOCIETY, PITTSBURG, PA, US, vol. 670, 17 April 2001 (2001-04-17), pages K2201-K2206, XP008008101 ISSN: 0272-9172
• WILK G D ET AL: "HIGH-KAPPA GATE DIELECTRICS: CURRENT STATUS AND MATERIALS PROPERTIES CONSIDERATIONS" JOURNAL OF APPLIED PHYSICS, AMERICAN INSTITUTE OF PHYSICS. NEW YORK, US, vol. 89, no. 10, 15 May 2001 (2001-05-15), pages 5243-5275, XP001049066 ISSN: 0021-8979

**EP 1 383 162 B1**

**Description**

The present invention relates to a method for depositing a dielectric layer, and more particularly, to a method for depositing a dielectric layer using a barrier layer, which prevents the oxidization and diffusion of a lower electrode.

A dielectric layer having a high dielectric constant is used as a buffer layer for forming a large gallium-arsenide (GaAs) substrate, a capacitor, and a gate insulating layer in a memory device. In particular, the dielectric layer is mainly used in a capacitor in a memory, such as a dynamic random access memory (DRAM). Here, since the memory has become highly integrated, a capacitor having a high capacitance is required to form semiconductor devices within a limited area.

A capacitor is formed of conductors facing each other and of a dielectric layer therebetween to attain a capacitance of a predetermined level. The capacitance of a capacitor is directly proportional to the effective area and the dielectric constant of a dielectric layer and in inversely proportional to the thickness of the dielectric layer. Thus, when a capacitor is formed by using a material having a high dielectric constant while reducing the thickness of the capacitor and increasing an effective area, a capacitance increases. In order to increase the effective area of a capacitor in a memory device, such as a DRAM, the effective area of a dielectric layer deposited on a lower electrode is increased by forming the lower electrode on vertical, having a reduced width and an increased height.

WO 02/31875 A2 discloses the manufacturing of a nanolaminate dielectric stack comprising dielectric layers of high-k material and oxidation preventing interface layers made of $Al_2O_3$ interposed between the dielectric layers.

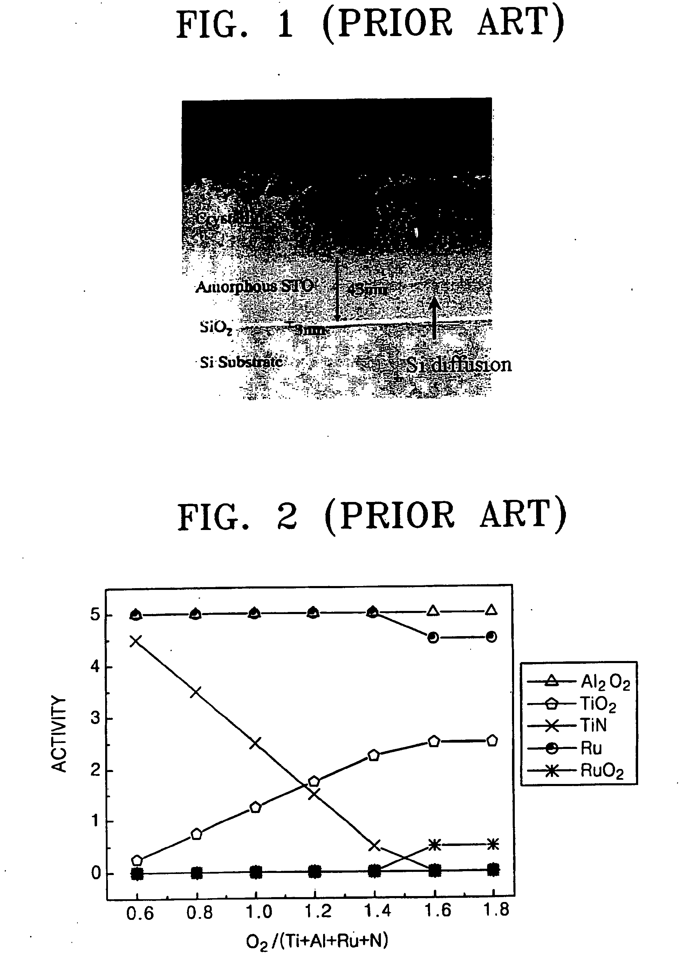

FIG. 1 is a transmission electron microscope (TEM) photograph illustrating a multi-layer formed by depositing a strontium titanate (STO;$SrTiO_3$) dielectric layer on a silicon (Si) substrate. In the case of depositing the STO dielectric layer on the Si substrate as shown in FIG. 1, the Si substrate is likely to be oxidized by oxygen introduced in an oxide layer deposition process so that a silicon dioxide ($SiO_2$) dielectric layer is formed on the Si substrate. In addition, amorphous $SiO_2$ causes disorder in a lattice arrangement of an initial STO dielectric layer. Furthermore, a portion of the Si substrate is diffused to the STO dielectric layer in a subsequent thermal process so that the crystalline STO dielectric layer is broken. Referring to FIG. 1, a capacitor in which the $SiO_2$ dielectric layer and the STO dielectric layer are sequentially arranged on the Si substrate is formed in a structure where a capacitor formed of the STO dielectric layer and the capacitor formed of the $SiO_2$ dielectric layer are sequentially connected. Therefore, the capacitance of the capacitor is reduced and electric characteristics of the capacitor deteriorate.

In order to solve the above-problems, a method for depositing a dielectric layer after forming a metal electrode, such as ruthenium (Ru) or titanium nitride (TiN), on an Si substrate has been developed. FIG. 2 is a graph illustrating the relationship between the ratio of oxygen to the content of metal ($O_2$/(Ti+Al+Ru+N)) and the activities of each metal in the case where an STO dielectric layer is deposited after TiN and Ru metal electrodes are deposited on an Si substrate.

Referring to FIG. 2, the activity of Ru is high in an oxidation atmosphere for depositing a dielectric layer so that Ru is likely to be transformed into ruthenium oxide ($RuO_2$) so that a thermal process of high temperature cannot performed on Ru. In addition, TiN located between Si and Ru is transformed into titanium oxide ($TiO_2$) according to following chemical formula 1 and the activity of TiN suddenly drops. Thus, TiN is likely to be broken so that it is difficult to produce a capacitor on vertical having a thickness of less than 70 nm by using TiN.

[chemical formula 1]        $2\,TiN + 2O_2 \rightarrow 2\,TiO_2 + N_2$

In addition, a capacitor formed in a memory device, such as a DRAM, stores a small number of charges so that information loss occurs due to even a weak leakage current. Therefore, a method for depositing a dielectric layer and preventing such a leakage current are required.

To solve the above and related problems, it is an objective of the present invention to provide a method for depositing a dielectric layer having a high dielectric constant and a low leakage current in order to prevent the generation of a low dielectric layer between a silicon layer and a dielectric layer

To accomplish the objective of the present invention, there is provided a method for depositing a dielectric layer having a multilayer structure on a substrate, comprising:

forming an oxidation barrier layer (10) on a surface substrate (11);
forming a plurality of dielectric layers (13) on the oxidation barrier layer (10),
wherein one of a plurality of additional oxidation barrier layers (10) is disposed between each dielectric layer and an adjacent layer (13, 15, 17); and
the oxidation barrier layer (10) is formed of one selected from groups 4 and 5 metal oxides and the dielectric layer is formed from strontium titanate (STO), barium titanate (BTO), barium strontium titanate (BST), lead lanthanum titanate (PLT), lead tantalum zirconium (PLZ) or strontium bismuth tantalite (SBT).

Here, the oxidation barrier layer is generally formed of a metal oxide such as one selected from groups 4, and 5 metal oxide layers, in particular, the metal oxide layer is selected from tantalum oxide (TaO), titanium oxide (TiO$_2$), hafnium oxide (HfO$_2$), and zirconium oxide (ZrO$_2$).

It is preferable that the metal of the oxidation barrier layer is diffused into the dielectric layer by depositing the dielectric layer and subsequently performing a thermal process, and the thermal process is performed at a temperature of lower than 700°C.

It is preferable that the dielectric layer is deposited by a chemical vapor deposition (CVD) method, and the oxidation barrier layer is deposited by an atomic layer deposition (ALD) method or a CVD method.

The dielectric layer is formed of one selected from strontium titanate (STO), barium titanate (BTO), barium strontium titanate (BST), lead lanthanum titanate (PLT), lead tantalum zirconium (PLZ), and strontium bismuth tantalite (SBT).

In the present invention, oxidation barrier layers are deposited between a substrate and a dielectric layer and between the dielectric layers so that the generation of a low dielectric layer, such as SiO$_2$, is prevented by preventing the oxidation of the silicon substrate and a multi-layer structure having a high dielectric constant and a low leakage current is attained.

The above objectives and advantages of the present invention will become more apparent by describing in detail preferred embodiments thereof with reference to the attached drawings in which:

FIG. 1 is a transmission electron microscope (TEM) photograph illustrating a multi-layer formed by depositing strontium titanate (STO;SrTiO$_3$) on a silicon (Si) substrate;

FIG. 2 is a graph illustrating activities of each material in the case where a dielectric layer is deposited by using a conventional metal interconnection;

FIGS. 3A through 3D are sectional views illustrating a method for depositing a dielectric layer according to the present invention;

FIG. 4A is a TEM photograph illustrating a multi-layer of STO/hafnium oxide (HfO$_2$)/STO before a method for depositing a dielectric layer according to the present invention is used;

FIG. 4B is a TEM photograph illustrating a multi-layer thin film transformed from the multi-layer of FIG. 4A by a thermal process of 700°C;

FIG. 5 is a sectional view illustrating a DRAM structure having capacitors on which a dielectric layer is deposited by a method for depositing a dielectric layer according to the present invention;

FIG. 6A is an enlarged sectional view illustrating portion A of FIG. 5;

FIG. 6B is an enlarged sectional view illustrating portion B of FIG. 5;

FIG. 7 (for reference) is a graph illustrating changes in a leakage current according to the changes in a voltage in a multi-layer of aluminum oxide (AlO)/STO deposited by a method for depositing a dielectric layer analogous to the present invention; and

FIG. 8 (for reference) is a graph illustrating the changes in a capacitance according to the changes in the thickness of AlO in a multi-layer of AlO/STO deposited by a method for depositing a dielectric layer analogous to the present invention.

A method for depositing a dielectric layer according to the present invention will now be described more fully with reference to the accompanying drawings, in which preferred embodiments of the invention are shown.

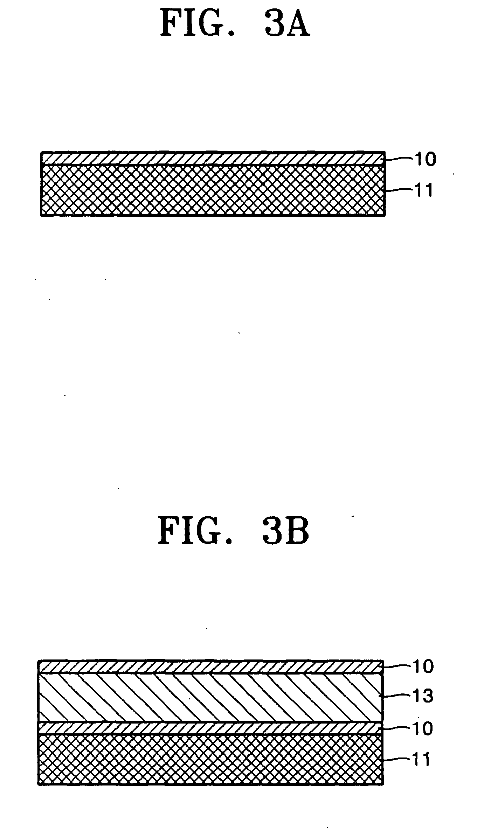

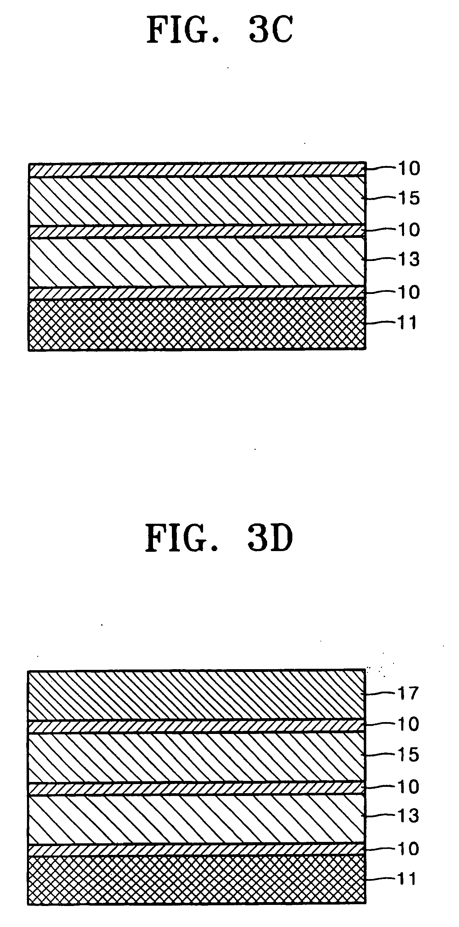

FIGS. 3A through 3D are sectional process views illustrating a method for depositing a dielectric layer according to the present invention. As shown in FIG. 3A, an oxidation barrier layer 10 is deposited on a substrate 11. Thereafter, a first dielectric layer 13 is deposited on the oxidation barrier layer 10 and an oxidation barrier layer 10 is deposited on the first dielectric layer as shown in FIG. 3B. A second dielectric layer 15 is deposited on the oxidation barrier layer 10 and an oxidation barrier layer 10 is deposited in the same manner as shown in FIG. 3C. As shown in FIG. 3D, a third dielectric layer 17 is deposited on the oxidation barrier layer 10 to complete a multi-layer structure having a three-fold dielectric layer.

A method for depositing a dielectric layer according to the present invention prevents oxidation by inserting the oxidation barrier layers between the substrate and the dielectric layer, and between the dielectric layers. Here, the first through third dielectric layers 13, 15, and 17 may be formed of the same material or different materials. Although three dielectric layers are formed in the present invention, more layers can be formed.

The oxidation barrier layers 10 are formed of dielectric layers, such as groups 4, and 5 metal electrodes or oxides thereof, which are much easily oxidized than the material used as the substrate 11. Examples of the metal electrodes or oxides thereof include tantalum (Ta), titanium (Ti), hafnium (Hf), and zirconium (Zr) or tantalum oxide (TaO), titanium oxide (TiO$_2$), hafnium oxide (HfO$_2$), and zirconium oxide (ZrO$_2$). Here, the oxidation barrier layers 10 have a thickness of several to tens of nanometres (tens to hundreds Å) and the thickness of the oxidation barrier layers 10 can be preferably adjusted according to the structure of a device. The oxidation barrier layers 10 are deposited by an atomic layer deposition (ALD) method. The ALD method is a thin film deposition technique using the chemical adsorption and desorption of an atomic layer. Here, each reactant material is separated and supplied to a chamber in a pulse type so that the reactant material is deposited on the substrate by the chemical adsorption and desorption according to the saturated surface reaction of the reactant material.

The first through third dielectric layers 13, 15, and 17 are formed of a dielectric material having a high dielectric constant K, for example, strontium titanate (STO;SrTiO3), lead lanthanum titanate (PLT), barium titanate (BTO), barium strontium titanate (BST), lead tantalum zirconium (PLZ), and strontium bismuth tantalite (SBT).

The dielectric layers 13, 15, and 17 are deposited by an ALD method or a chemical vapor deposition (CVD) method. Here, the CVD method is a technique where vapor injected to a reactor chemically reacts on a substrate by energy, such as heat or plasma, so as to form a thin layer. The CVD method can obtain a crystalline layer or an amorphous layer having high purity and no defect at a relatively low temperature. In addition, the CVD method can form various kinds of thin layers and easily adjust stoichoiometric composition.

The method for depositing a dielectric layer according to the present invention further includes a thermal process in a high temperature oxidation atmosphere after forming a multi-layer structure where the dielectric layers are deposited by inserting the oxidation barrier layers 10 into the interfaces of the dielectric layers on the substrate 11. If the thermal process is continuously performed, the metal atoms of the oxidation barrier layers 10 are diffused to the first through third dielectric layers 13, 15, and 17, and the diffused metal atoms are cooled and crystallized so that the lattice constant of the first through third dielectric layers 13, 15, and 17 may be changed. When the ion radius of the metal atoms of the oxidation barrier layers 10 is small, the lattice constant of the first through third dielectric layers 13, 15, and 17 is reduced. In the reverse case, the lattice constant of the dielectric layers 13, 15, and 17 is increased. The lattice constant a of the STO dielectric layer is 0.3905 nm when the method for depositing a dielectric layer according to the present invention is performed. However, when the Hf atoms are diffused after the thermal process, the lattice constant a of the STO dielectric layer increases to 0.3923 nm.

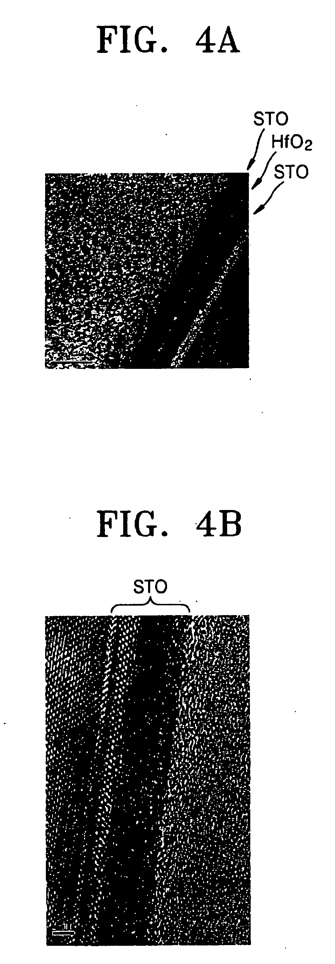

FIG. 4A is a TEM photograph illustrating a multi-layer of STO/$HfO_2$/STO deposited by a method for depositing a dielectric layer according to the present invention. FIG. 4B is a TEM photograph illustrating a multi-layer transformed from the multi-layer of FIG. 4A by a thermal process.

Referring to FIG. 4A, a $HfO_2$ layer is inserted between STO layers. When a thermal process is performed, the $HfO_2$ layer is diffused to dielectric layers and terminated. Here, a distance between the STO dielectric layers is changed from 0.3905 nm to 0.3923 nm by the thermal process. In the case where a layer, such as gallium-arsenide (GaAs), is deposited on the STO layer, the changed crystalline layers may relieve stress due to incongruence of the lattice constant. Here, the structure of inserting an oxidation barrier layer onto an STO dielectric layer and depositing a GaAs layer can be used for manufacturing an optical recording medium.

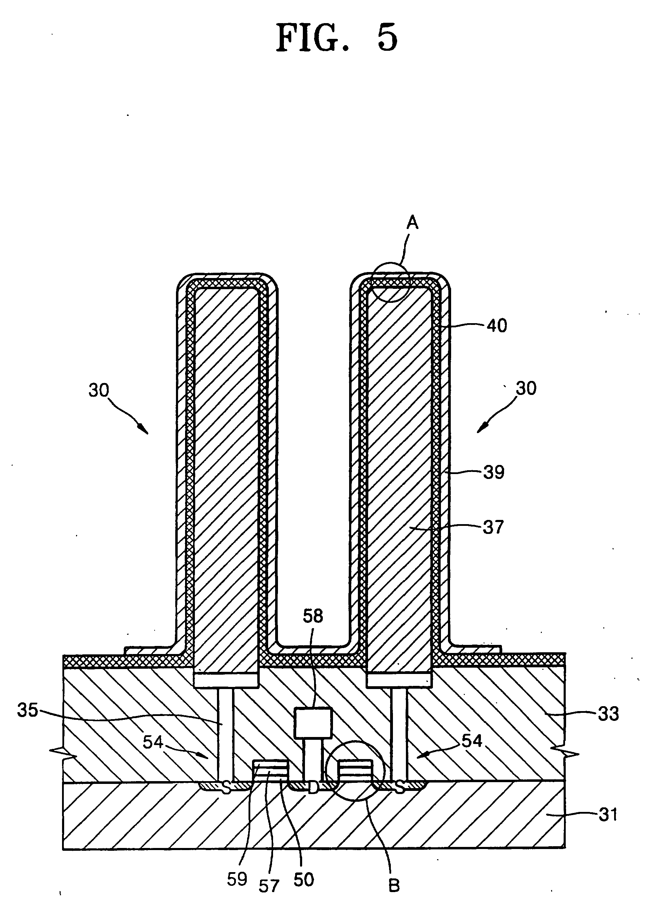

FIG. 5 is a schematic view illustrating a DRAM structure having two capacitors 30 having a dielectric layer 40 deposited by a method for depositing a dielectric layer according to the present invention.

Referring to FIG. 5, the DRAM has two transistors 54 and two capacitors 30. The transistors 54 are each formed of source electrodes S, a drain electrode D, and gate electrodes 57 where word lines 59 are arranged on the gate electrodes 57 in a stripe type and a bit line 58 is formed between the gate electrodes 57.

More specifically, the source electrodes S and the drain electrode D are formed on the surface of a substrate 31 to a predetermined depth and the gate electrodes 57 are disposed between the source and drain electrodes S and D. Between the gate electrode 57 and the substrate 31, a plurality of dielectric layers 53 and 55 as insulating layers and a plurality of oxidation barrier layers 51 are alternately stacked. Conductive plugs 35 are located to contact the source electrodes S in an insulating layer 33 and column shaped lower electrodes 37 are located on the conductive plugs 35. A multi-layer dielectric layer 40 is deposited on the lower electrodes 37 and an upper electrode 39 is deposited on the multi-layer dielectric layer 40.

FIG. 6A is an enlarged sectional view illustrating portion A of FIG. 5 that illustrates the multi-layer structure 40 of the capacitor 30. An oxidation barrier layer 41 is deposited on the lower electrode 37 and a first dielectric layer 43, the oxidation barrier layer 41, and a second dielectric layer 45 are sequentially deposited to form the multi-layer dielectric layer 40. The upper electrode 39 is deposited on the multi-layer dielectric layer 40 to complete a capacitor.

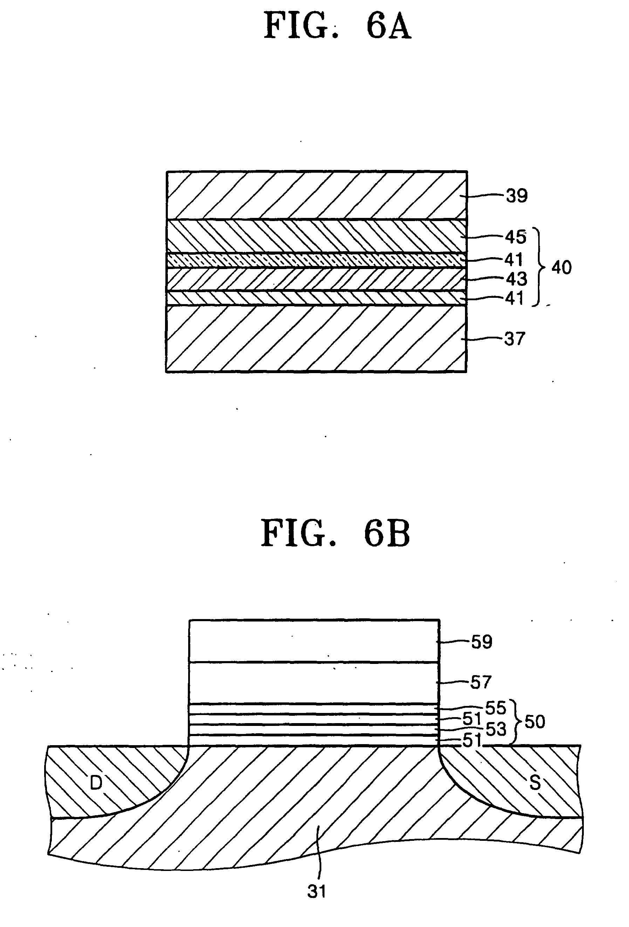

FIG. 6B is an enlarged sectional view illustrating portion B of FIG. 5 that illustrates the structure of a transistor 54. A word line 59 is located between source and drain electrodes S and D, and a gate electrode 57 is formed beneath the word line 59. An oxidation barrier layer 51, a first dielectric layer 53, the oxidation barrier layer 51, and a second dielectric layer 55 are sequentially deposited between the gate electrode 57 and the substrate 31 to form a multi-layer structure 50.

The capacitor having a multi-layer dielectric layer where the oxidation barrier layers 51 and dielectric layers 53 and 55 are alternately formed reduces a leakage current and increases a capacitance.

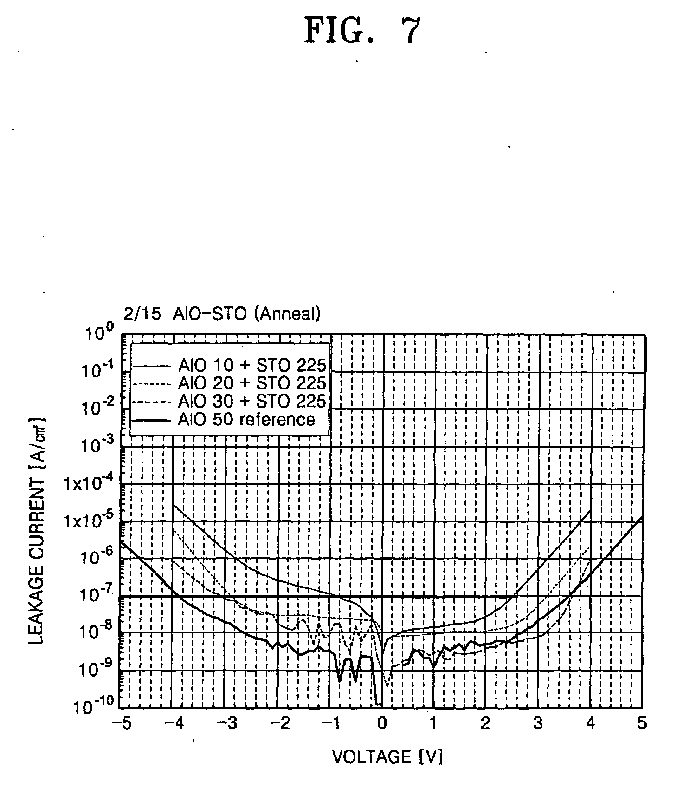

FIG. 7 (reference) is a graph illustrating the changes in a leakage current according to the changes in a voltage when an oxidation barrier layer of AIO and a dielectric layer of STO are deposited by a method for depositing a dielectric layer analogous to the present invention.

Referring to FIG. 7, if the thickness of the STO dielectric layer is kept constant at 22.5 nm, the thickness of the oxidation barrier layer of AlO is varied to 1, 2, 3, and 4 nm, and a voltage range is from - 4 to 3 V, the leakage current is smaller than $10^{-7}$A/cm$^2$, i.e., a reference leakage current. Since the leakage current is almost the same as a minimum leakage current value according to the changes in the voltage of the oxidation barrier layer of AlO, the leakage current is considered to be considerably reduced.

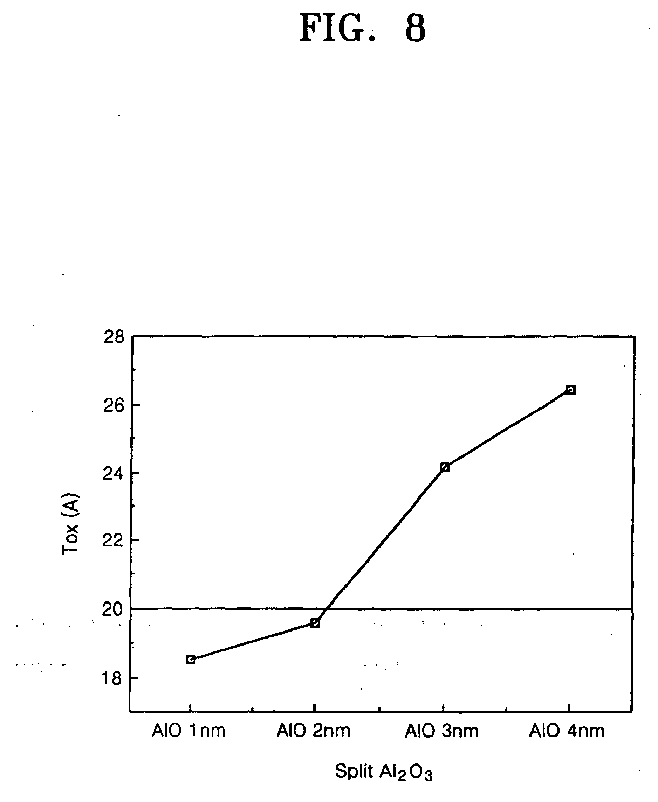

FIG. 8 (reference) is a graph illustrating the changes in the capacitance according to the changes in AlO when an oxidation barrier layer of AlO and a dielectric layer of STO are deposited by a method for depositing a dielectric layer to the present invention.

Referring to FIG. 8, the X-axis denotes the changes in the thickness of AlO and the Y-axis denotes the changes in a capacitance, which is converted into the thickness of SiO$_2$. When the SiO$_2$ is established to a thickness of 2nm (20 Å) as the thickness of a reference capacitance, the converted thickness of a multi-layer structure is smaller than the thickness of the reference capacitance in the case where the thickness of AlO is lower than 2 nm. As a result, the capacitance becomes larger than the reference capacitance, because capacitance C is in inverse proportion to thickness **d** as shown in Equation 1.

$$C = \varepsilon \frac{s}{d} \qquad \cdots\cdots\cdots\cdots (1)$$

Here, $\varepsilon$ denotes a dielectric constant and $s$ denotes the area of a capacitor.

A multi-layer structure deposited by using a method for depositing a dielectric layer according to the present invention results in a low leakage current and a high capacitance. Thus, the multi-layer structure according to the present invention may be used in various electronic devices and optical devices, such as a memory device requiring high performance and an optical recording medium.

The method for depositing a dielectric layer according to the present invention has the advantages of obtaining a capacitor and a gate insulating layer having a low leakage current and a high capacitance by controlling the lattice constant of a dielectric layer and manufacturing a substrate, such as a large GaAs, by controlling the surface distance between crystals.

## Claims

**1.** A method for depositing a dielectric layer having a multilayer structure on a substrate, comprising:

forming an oxidation barrier layer (10) on a surface substrate (11);
forming a plurality of dielectric layers (13) on the oxidation barrier layer (10),
wherein one of a plurality of additional oxidation barrier layers (10) is disposed between each dielectric layer and an adjacent Layer (13, 15, 17) ; and
the dielectric layer is formed from strontium titanate (STO), barium titanate (BTO), barium strontium titanate (BST), lead lanthanum titanate (PLT), lead tantalum zirconium (PLZ) or strontium bismuth tantalite (SBT) **characterised in that** the oxidation barrier layer (10) is formed of one selected from groups 4 and 5 metal oxides.

**2.** The method according to claim 1, wherein the metal oxide layer is selected from tantalum oxide (TaO), titanium oxide (TiO$_2$), hafnium oxide (HfO$_2$), and zirconium oxide (ZrO$_2$).

**3.** The method according to claim 1 or 2, wherein the metal of the oxidation barrier layer (10) is diffused into the dielectric layer (13, 15, 17) by depositing the dielectric layer and subsequently performing a thermal process in a high temperature oxidation atmosphere.

**4.** The method according to claim 3, wherein the thermal process is performed at a temperature of lower than 700° C.

**5.** The method according to any of claims 1 to 4, wherein the dielectric layer (13, 15, 17) is deposited by a chemical vapor deposition (CVD) method.

**6.** The method according to any of claims 1 to 5, wherein the oxidation barrier layer (10) is deposited by an atomic layer deposition (ALD) method or a CVD method.

**Patentansprüche**

1. Verfahren zum Abscheiden einer dielektrischen Schicht mit einer Mehrschichtstruktur auf einem Substrat, umfassend:

    Ausbilden einer Oxidationsbarriereschicht (10) auf einer Substratoberfläche (11);
    Ausbilden einer Mehrzahl von dielektrischen Schichten (13) auf der Oxidationsbarriereschicht (10),

    wobei eine einer Mehrzahl von zusätzlichen Oxidationsbarriereschichten (10) zwischen jeder dielektrischen Schicht und einer angrenzenden Schicht (13, 15, 17) angeordnet wird; und
    die dielektrische Schicht aus Strontiumtitanat (STO), Bariumtitanat (BTO), Bariumstrontiumtitanat (BST), Bleilanthantitanat (PLT), Bleitantalzirconium (PLZ) oder Strontiumbismuttantalit (SBT) gebildet wird, **dadurch gekennzeichnet, dass** die Oxidationsbarriereschicht (10) aus einem Metalloxid ausgewählt aus Metalloxiden der Gruppe 4 und 5 gebildet wird.

2. Verfahren nach Anspruch 1, wobei die Metalloxidschicht ausgewählt wird aus Tantaloxid (TaO), Titanoxid (TiO$_2$), Hafniumoxid (HfO$_2$) und Zirconiumoxid (ZrO$_2$).

3. Verfahren nach Anspruch 1 oder 2, wobei das Metall der Oxidationsbarriereschicht (10) in die dielektrische Schicht (13, 15, 17) diffundiert, indem die dielektrische Schicht abgeschieden wird und anschließend ein thermischer Prozess in einer Hochtemperaturoxidationsatmosphäre durchgeführt wird.

4. Verfahren nach Anspruch 3, wobei der thermische Prozess bei einer Temperatur unter 700 °C durchgeführt wird.

5. Verfahren nach einem der Ansprüche 1 bis 4, wobei die dielektrische Schicht (13, 15, 17) durch ein chemisches Aufdampfverfahren (CVD, Chemical Vapor Deposition) abgeschieden wird.

6. Verfahren nach einem der Ansprüche 1 bis 5, wobei die Oxidationsbarriereschicht (10) nach einem ALD-Beschichtungsverfahren (ALD, Atomic Layer Deposition) oder einem CVD-Verfahren abgeschieden wird.


**Revendications**

1. Procédé de dépôt d'une couche diélectrique à structure multicouche sur un substrat, comprenant :

    la formation d'une couche barrière anti-oxydation (10) sur un substrat de surface (11) ;
    la formation d'une pluralité de couches diélectriques (13) sur la couche barrière anti-oxydation (10),
    une couche barrière anti-oxydation d'une pluralité de couches barrières anti-oxydation supplémentaires (10) étant disposée entre chaque couche diélectrique et une couche diélectrique (13, 15, 17) adjacente ; et
    la couche diélectrique étant constituée à partir de titanate de strontium (STO), titanate de baryum (BTO), titanate de baryum et de strontium (BST), titanate de plomb et de lanthane (PLT), plomb tantale zirconium (PLZ) ou de strontium bismuth tantalite (SBT),

    **caractérisé en ce que**
    la couche barrière anti-oxydation (10) est constituée à partir d'un oxyde de métal choisi parmi les groupes 4 et 5.

2. Procédé selon la revendication 1, dans lequel la couche d'oxyde de métal est sélectionnée parmi l'oxyde de tantale (TaO), l'oxyde de titane (TiO$_2$), l'oxyde de hafnium (HfO$_2$), et l'oxyde de zirconium (ZrO$_2$).

3. Procédé selon la revendication 1 ou 2, dans lequel le métal de la couche barrière anti-oxydation (10) est diffusé dans la couche diélectrique (13, 15, 17) par dépôt de la couche diélectrique puis mise en oeuvre d'un processus thermique sous une atmosphère oxydante à haute température.

4. Procédé selon la revendication 3, dans lequel le processus thermique est mis en oeuvre à une température inférieure à 700 °C.

5. Procédé selon l'une quelconque des revendications 1 à 4, dans lequel la couche diélectrique (13, 15, 17) est déposée selon un procédé de dépôt chimique en phase vapeur (CVD).

6. Procédé selon l'une quelconque des revendications 1 à 5, dans lequel la couche barrière anti-oxydation (10) est déposée selon un procédé de dépôt de couche atomique (ALD) ou un procédé CVD.

# FIG. 1 (PRIOR ART)

# FIG. 2 (PRIOR ART)

# FIG. 3A

## FIG. 3B

# FIG. 3C

```
                                    ─10
                                    ─15
                                    ─10
                                    ─13
                                    ─10
                                    ─11
```

# FIG. 3D

```
                                    ─17
                                    ─10
                                    ─15
                                    ─10
                                    ─13
                                    ─10
                                    ─11
```

# FIG. 4A

# FIG. 4B

# FIG. 5

# FIG. 6A

# FIG. 6B

# FIG. 7

2/15 AlO-STO (Anneal)

Legend:
- AlO 10 + STO 225
- AlO 20 + STO 225
- AlO 30 + STO 225
- AlO 50 reference

Y-axis: LEAKAGE CURRENT [A/cm²]

X-axis: VOLTAGE [V]

# FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0231875 A2